# FASCICULE DE BREVET EUROPEEN

(11) **EP 4 333 576 B1**
(45) Date de publication et mention de la délivrance du brevet: **26.02.2025**
(21) Numéro de dépôt: 22306292.8
(22) Date de dépôt: 31.08.2022
(51) Int. Cl.: H05K 7/20

(54) **DISSIPATEUR THERMIQUE DE SORTIE POUR SYSTÈME DE REFROIDISSEMENT D'UNE CARTE ÉLECTRONIQUE DE SUPERCALCULATEUR**
AUSGANGSKÜHLKÖRPER FÜR EIN KÜHLSYSTEM EINER ELEKTRONISCHEN SUPERRECHNERKARTE
OUTPUT HEAT SINK FOR A COOLING SYSTEM OF A SUPERCOMPUTER ELECTRONIC BOARD

(43) Date de publication de la demande: 06.03.2024
(73) Titulaire: BULL SAS, 78340 Les Clayes-Sous-Bois (FR); Commissariat à l'Energie Atomique et aux Energies Alternatives, 75015 Paris (FR)
(72) Inventeur: RAETH, Marc, 78910 TACOIGNIERES (FR); DALLASERRA, Luc, 75009 PARIS (FR)
(74) Mandataire: Argyma

(56) Documents cités:
- EP-A1- 3 500 079
- US-A1- 2016 118 317
- US-A1- 2018 340 744

## Description

### [Domaine technique]

La présente invention se rapporte au domaine du refroidissement des processeurs informatiques et concerne plus particulièrement un système de refroidissement liquide d'une carte électronique comprenant au moins un processeur de calcul.

### [Etat de la technique antérieure]

Les lames de calcul pour serveur comportent généralement des cartes électroniques, notamment des processeurs, qui dégagent de la chaleur et doivent donc être refroidies. Initialement, ces cartes électroniques étaient refroidies par de l'air. Toutefois, dans le cas de serveurs montables sur bâti, la circulation d'air n'est pas suffisante pour refroidir les cartes électroniques. Pour résoudre ce problème, des systèmes de refroidissement fluidiques ont été développés.

Parmi les solutions connues de refroidissement de cartes électroniques, la société IBM^{®} a mis au point un système de refroidissement mixte de cartes électroniques double processeur pour supercalculateur. Un tel système comporte des tuyaux en cuivre contenant un liquide caloporteur formant une boucle liquide. Toutefois, la rigidité des tuyaux en cuivre ne permet pas le démontage rapide d'un unique processeur. En outre, la boucle liquide assure le refroidissement des processeurs uniquement. Le reste de la puissance dissipée est refroidie par convection dans l'air, ce qui n'est pas optimal pour l'efficacité énergétique (PUE, acronyme désignant en anglais « Power Usage Effectiveness ») du supercalculateur.

D'autres fabricants de cartes électroniques proposent des systèmes de refroidissement liquides dédiés uniquement aux processeurs. Ces derniers intègrent un dissipateur thermique, une pompe intégrée et un échangeur pour extraire les calories. Bien entendu, de tels dispositifs ne sont pas compatibles avec des systèmes de plus grande échelle comme les supercalculateurs pour des raisons d'encombrement.

La demanderesse a mis au point, par ailleurs, un système de refroidissement mixte dans lequel les cartes électroniques sont refroidies par l'intermédiaire d'une plaque froide en aluminium dans laquelle circule un liquide caloporteur, la plaque froide étant interfacée avec tous les composants électroniques bas et moyens à refroidir, c'est-à-dire l'ensemble des composants d'une carte électronique à l'exclusion des composants électroniques hauts (typiquement les processeurs et les barrettes mémoires). Les processeurs sont les composants les plus contraignants à refroidir (car ils doivent rester accessibles) et aussi les plus dissipatifs. Ils ne peuvent pas être interfacés avec la plaque froide directement. Afin d'assurer le contact thermique avec les processeurs, chacun d'eux est interfacé avec un dissipateur thermique intermédiaire à caloducs. Il s'agit d'un dissipateur thermique diphasique à changement de phase (généralement désigné en anglais par les termes « Heat Spreader CPU »), qui conduit la chaleur des processeurs vers la plaque froide. La partie des caloducs en contact avec la dalle en cuivre qui interface le processeur constitue l'évaporateur, tandis que celle en contact avec l'interface avec la plaque froide constitue le condenseur. Cette solution est décrite de manière plus détaillée dans les demandes de brevet européen EP 2770809 et EP 2770810 appartenant à la demanderesse.

Cette solution de refroidissement des processeurs à l'aide de caloducs présente également des inconvénients, et en particulier :
- des limites thermiques spécifiques aux caloducs : l'écoulement à l'intérieur d'un caloduc est diphasique et est régi par cinq limites en termes d'écoulement, de viscosité, d'ébullition, d'entraînement, de capillarité, qui dépendent des dimensions des caloducs et de la puissance à évacuer.
- des limites mécaniques : l'augmentation du nombre de caloducs entraîne une augmentation de la rigidité de l'ensemble. Or, afin de compenser les écarts de tolérances, il est indispensable que le dissipateur se déforme suffisamment.
- un nombre élevé d'interfaces thermiques amovibles : des contacts thermiques doivent être assurés entre la plaque froide et le dissipateur thermique d'une part, et entre le dissipateur thermique et le processeur. Ces contacts thermiques sont, dans la solution actuelle mise en place par le demandeur, garantis par l'utilisation de graisse conductrice, présentant l'inconvénient de générer un gradient de température élevé.
- la complexité et le coût de la solution globale : les surfaces d'échanges solide/fluide sont actuellement au niveau de la plaque froide. La complexité de celle-ci au niveau des dissipateurs thermiques augmente considérablement les usinages dans la plaque froide et ainsi le coût de fabrication.

Pour résoudre les défauts et inconvénients susmentionnés, la demanderesse a mis au point un système de refroidissement pour une carte électronique qui est entièrement liquide, comprenant une plaque froide alimentée en fluide caloporteur via un chemin d'eau interne à la plaque froide, et une pluralité de dissipateurs thermiques reliés en liaisons souples avec le chemin d'eau interne à la plaque froide. Ces liaisons souples forment un réseau flexible couplé au réseau de canaux rigides de la plaque froide alimenté en fluide caloporteur (typiquement de l'eau glycolée), permettant ainsi l'alimentation en fluide caloporteur des dissipateurs thermiques. Ce réseau est couplé au système de plaque froide permettant le refroidissement du reste de la carte électronique. Pour optimiser au maximum le refroidissement du processeur, le liquide caloporteur doit être amené au plus proche de la source de chaleur. A cette fin, la demanderesse a mis spécifiquement au point un dissipateur thermique monophasique comportant un bloc de refroidissement en matériau thermoconducteur pouvant être alimenté en fluide caloporteur. La source de chaleur que constitue le processeur sera donc directement interfacée avec ce bloc de refroidissement (également désigné dans les exemples par le terme en anglais « waterblock ») alimenté en fluide caloporteur prélevé de la plaque froide. Un tel système de refroidissement intégré répond aux contraintes d'efficacité thermique, de compacité mécanique et de maintenabilité nécessaire pour ce type de matériel informatique haute performance. Cette solution est décrite en détail dans le document WO2019115963.

De manière connue, les calculateurs multiprocesseurs nécessitent autant de blocs de refroidissement que de processeurs.

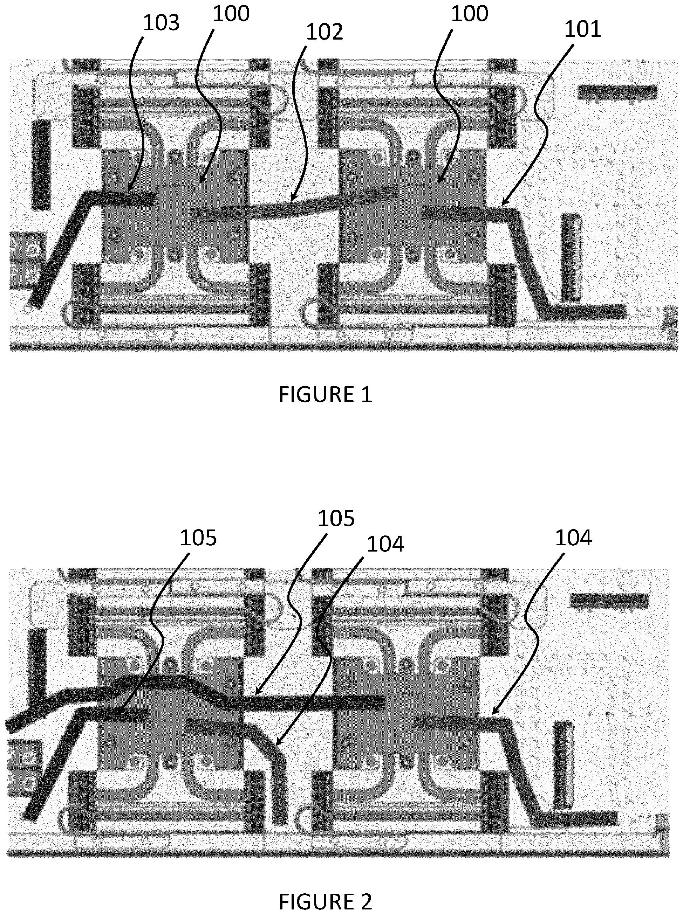

Pour une chaîne de composants donnée, dans une solution connue illustrée sur la figure 1, les échangeurs thermiques 100 sont montés en série, c'est-à-dire que l'entrée du premier échangeur 100 est reliée à une arrivée de liquide via un flexible d'entrée 101, sa sortie est reliée à l'entrée de l'échangeur 100 suivant via un flexible de liaison 102 et ainsi de suite jusqu'à la sortie du dernier échangeur 100 qui est relié à une sortie de liquide via un flexible de sortie 103. Comme les échangeurs sont en série, la température du liquide augmente à mesure qu'il s'approche de la sortie de liquide (le liquide est plus chaud quand il arrive dans le dernier échangeur puisqu'il a déjà servi à refroidir les échangeurs précédents) et donc les composants situés en fin de chaîne sont moins bien refroidis que ceux en début de chaîne. De plus, cette solution rend compliquée la maintenance des composants puisqu'il faut démonter tous les échangeurs en liaison flexible pour changer un composant de la chaîne, notamment au-delà de deux échangeurs en série.

Afin de pallier au moins en partie ces inconvénients, il est connu de monter les échangeurs 100 en parallèle et non plus en série, comme illustré sur la figure 2. Ainsi, chaque processeur est refroidi de manière indépendante des autres et chaque bloc de refroidissement peut être changé facilement en cas de problème. Cette solution présente toutefois l'inconvénient de nécessiter autant de connecteurs (non représentés par souci de clarté) et de flexibles d'entrée 104 que de processeurs et autant de connecteurs (non représentés par souci de clarté) et de flexibles de sortie 105 que de processeurs. Or, les connecteurs et les flexibles d'entrée 104 et les connecteurs et flexibles de sortie 105 nécessitent un volume d'espace significatif pour être reliés à la plaque froide. Cependant, dans les calculateurs multiprocesseurs, le manque d'espace peut s'avérer bloquant pour installer une telle solution.

Il serait donc avantageux de proposer une solution simple, fiable et efficace permettant de remédier au moins en partie à ces inconvénients.

### [Exposé de l'invention]

Un but de l'invention est donc de fournir une solution de refroidissement d'une carte électronique, notamment de supercalculateur. Dans ce but, l'invention définit plusieurs types de dissipateurs thermiques complémentaires ayant chacun une fonction spécifique ainsi qu'un système de refroidissement comportant de tels dissipateurs.

Ainsi, l'invention concerne tout d'abord un dissipateur thermique d'entrée pour un système de refroidissement liquide d'une carte électronique, ladite carte comportant au moins un composant électronique, par exemple un processeur, un régulateur de tension ou une barrette mémoire, par exemple monté(e) sur un support, ledit système comprenant une plaque froide destinée à recevoir ledit dissipateur thermique, ladite plaque froide étant dimensionnée pour recouvrir au moins en partie la carte électronique, notamment le support de l'au moins un composant électronique le cas échéant, et comprenant un circuit de refroidissement comportant des canaux à l'intérieur desquels circule un fluide caloporteur dit « froid » destiné à alimenter au moins ledit dissipateur thermique, et un circuit d'évacuation comportant des canaux à l'intérieur desquels circule un fluide caloporteur dit « chaud » s'étant réchauffé à travers le dissipateur thermique, le dissipateur thermique comprenant un bloc de refroidissement en matériau thermoconducteur comprenant une partie inférieure constituant la zone d'échange thermique principale et une partie supérieure destinée à être connectée à la plaque froide, le dissipateur étant remarquable en ce qu'il comprend :
- un connecteur d'entrée dit « froid » relié fluidiquement à la partie supérieure dudit bloc de refroidissement et qui est destiné à recevoir un tube d'entrée du circuit de refroidissement de sorte que ledit bloc de refroidissement soit alimenté par le fluide caloporteur provenant de la plaque froide,
- un connecteur de sortie dit « chaud »,
- un connecteur de sortie dit « froid »,
la partie supérieure du bloc de refroidissement étant configurée pour diviser le flux de fluide caloporteur entrant par le connecteur d'entrée froid en un premier flux, qui est orienté vers le partie inférieure du bloc de refroidissement de sorte à collecter la chaleur générée par la carte électronique en étant acheminé jusqu'au connecteur de sortie chaud, et un deuxième flux, orienté directement vers le connecteur de sortie froid.

Le dissipateur thermique d'entrée selon l'invention permet ainsi de conserver une partie du flux froid venant de la plaque froide pour le diriger vers un autre dissipateur connecté sur sa sortie, améliorant ainsi le refroidissement du ou des composants électroniques (processeur ou autre) situés en aval dans le sens de circulation du fluide caloporteur. Le dissipateur thermique d'entrée selon l'invention permet en outre de répondre à des contraintes de fabrication en grande série, en raison de sa simplicité de fabrication.

L'invention concerne également un dissipateur thermique de sortie pour un système de refroidissement liquide d'une carte électronique, ladite carte comportant au moins un composant électronique, par exemple un processeur, un régulateur de tension ou une barrette mémoire, par exemple monté(e) sur un support, ledit système comprenant une plaque froide destinée à recevoir ledit dissipateur thermique, ladite plaque froide étant dimensionnée pour recouvrir au moins en partie la carte électronique, notamment le support de l'au moins un composant électronique le cas échéant, et comprenant un circuit de refroidissement comportant des canaux à l'intérieur desquels circule un fluide caloporteur dit « froid », destiné à alimenter ledit dissipateur thermique, et un circuit d'évacuation comportant des canaux à l'intérieur desquels circule un fluide caloporteur dit « chaud » s'étant réchauffé à travers le dissipateur thermique, le dissipateur thermique comprenant un bloc de refroidissement en matériau thermoconducteur comprenant une partie inférieure constituant la zone d'échange thermique principale et une partie supérieure destinée à être connectée à la plaque froide, le dissipateur étant remarquable en ce qu'il comprend :
- un connecteur d'entrée dit « froid » relié fluidiquement à la partie supérieure dudit bloc de refroidissement et qui est destiné à recevoir un tube de liaison du circuit de refroidissement de sorte que ledit bloc de refroidissement soit alimenté par le fluide caloporteur provenant de la plaque froide (à travers au moins un dissipateur thermique),
- un connecteur d'entrée dit « chaud » relié fluidiquement à la partie supérieure dudit bloc de refroidissement et qui est destiné à recevoir un tube de liaison d'un flux de fluide caloporteur réchauffé,
- un connecteur de sortie dit « chaud »,
la partie supérieure du bloc de refroidissement étant configurée pour d'une part acheminer le flux de fluide caloporteur entrant par le connecteur d'entrée froid vers la partie inférieure du bloc de refroidissement de sorte à collecter la chaleur générée par la carte électronique en étant acheminé jusqu'au connecteur de sortie, et d'autre part acheminer le flux de fluide caloporteur réchauffé reçu sur le connecteur d'entrée chaud directement vers le connecteur de sortie où il fusionne avec le flux réchauffé dans la partie inférieure du bloc de refroidissement.

Le dissipateur thermique de sortie selon l'invention permet ainsi à la fois de recevoir un flux de fluide caloporteur froid et de fusionner les flux chauds venant à la fois de la partie inférieure du bloc de refroidissement et d'un dissipateur thermique amont connecté à l'entrée chaude dudit dissipateur thermique de sortie, améliorant ainsi le refroidissement du ou des composants électroniques associé audit dissipateur thermique de sortie tout en permettant la circulation du fluide caloporteur. Le dissipateur thermique de sortie selon l'invention permet en outre de répondre à des contraintes de fabrication en grande série, en raison de sa simplicité de fabrication.

Avantageusement, un dissipateur thermique d'entrée peut être connecté par paire avec un dissipateur thermique de sortie pour former un ensemble de dissipateurs thermiques selon l'invention.

L'invention concerne également un dissipateur thermique intercalaire pour un système de refroidissement liquide d'une carte électronique, ladite carte comportant au moins un composant électronique, par exemple un processeur, un régulateur de tension ou une barrette mémoire, par exemple monté(e) sur un support, ledit système comprenant une plaque froide destinée à recevoir ledit dissipateur thermique, ladite plaque froide étant dimensionnée pour recouvrir au moins en partie la carte électronique, notamment le support de l'au moins un composant électronique le cas échéant, et comprenant un circuit de refroidissement comportant des canaux à l'intérieur desquels circule un fluide caloporteur dit « froid », destiné à alimenter au moins ledit dissipateur thermique, et un circuit d'évacuation comportant des canaux à l'intérieur desquels circule un fluide caloporteur dit « chaud » s'étant réchauffé à travers le dissipateur thermique, le dissipateur thermique comprenant un bloc de refroidissement en matériau thermoconducteur comprenant une partie inférieure constituant la zone d'échange thermique principale et une partie supérieure destinée à être connectée à la plaque froide, le dissipateur étant caractérisé en ce qu'il comprend :
- un connecteur d'entrée dit « froid » relié fluidiquement à la partie supérieure dudit bloc de refroidissement et qui est destiné à recevoir un tube d'entrée du circuit de refroidissement de sorte que ledit bloc de refroidissement soit alimenté par le fluide caloporteur provenant de la plaque froide,
- un connecteur d'entrée dit « chaud » relié fluidiquement à la partie supérieure dudit bloc de refroidissement et qui est destiné à recevoir un tube de liaison d'un flux de fluide caloporteur réchauffé,
- un connecteur de sortie dit « chaud »,
- un connecteur de sortie dit « froid »,
la partie supérieure du bloc de refroidissement étant configurée pour :
- diviser le flux de fluide caloporteur entrant par le connecteur d'entrée froid en un premier flux, qui est orienté vers la partie inférieure du bloc de refroidissement de sorte à collecter la chaleur générée par la carte électronique en étant acheminé jusqu'au connecteur de sortie chaud, et un deuxième flux, orienté directement vers le connecteur de sortie froid,
- acheminer le flux de fluide caloporteur réchauffé reçu sur le connecteur d'entrée chaud directement vers le connecteur de sortie chaud où il fusionne avec le flux réchauffé dans la partie inférieure du bloc de refroidissement.

Ainsi, un ou plusieurs dissipateurs thermiques intercalaires peuvent être connectés entre un dissipateur thermique d'entrée et un dissipateur thermique de sortie d'un même ensemble de dissipateurs thermiques afin de refroidir plus de composants électroniques sur une même ligne tout en permettant un acheminement de fluide caloporteur froid sur les dissipateurs thermiques avals de l'ensemble.

L'invention concerne également un système de refroidissement liquide d'une carte électronique, ladite carte comportant au moins un composant électronique, par exemple un processeur, un régulateur de tension ou une barrette mémoire, par exemple monté(e) sur un support, ledit système comprenant une plaque froide et au moins un ensemble de dissipateurs thermiques, la plaque froide étant destinée à recevoir ledit ensemble de dissipateurs thermiques, étant dimensionnée pour recouvrir au moins en partie la carte électronique, notamment le support de l'au moins un composant électronique le cas échéant, et comprenant un circuit de refroidissement comportant des canaux à l'intérieur desquels circule un fluide caloporteur dit « froid », destiné à alimenter au moins un des dissipateurs thermiques, et un circuit d'évacuation comportant des canaux à l'intérieur desquels circule un fluide caloporteur dit « chaud » s'étant réchauffé à travers au moins un des dissipateurs thermiques, chaque dissipateur thermique comprenant une zone d'échange thermique principale apte à venir en appui contre l'un des processeurs, chaque ensemble de dissipateurs thermiques comprenant un dissipateur thermique d'entrée tel que présenté ci-avant et un dissipateur thermique de sortie tel que présenté ci-avant, le connecteur d'entrée du dissipateur thermique d'entrée étant relié fluidiquement au circuit de refroidissement par un tube d'entrée, le connecteur de sortie froid du dissipateur thermique d'entrée étant relié fluidiquement au connecteur d'entrée froid du dissipateur thermique de sortie, le connecteur de sortie chaud du dissipateur thermique d'entrée étant relié fluidiquement au connecteur d'entrée chaud du dissipateur thermique de sortie, le connecteur de sortie du dissipateur thermique de sortie étant relié au circuit d'évacuation par un tube de sortie.

Le système selon l'invention permet ainsi de refroidir efficacement la carte électronique en répartissant le fluide caloporteur froid entre le dissipateur thermique d'entrée et le dissipateur thermique de sortie d'un même ensemble de dissipateurs thermiques. Le système de refroidissement selon l'invention permet de garantir le refroidissement des composants de la carte électronique, et ce par voie liquide quelle que soit la nature des composants électroniques : les composants bas et moyens par la plaque froide et les composants dits hauts tels que les processeurs et les barrettes mémoires par les dissipateurs thermiques, notamment monophasiques, à bloc de refroidissement. Le système de refroidissement selon l'invention, en raison de sa structure avec blocs de refroidissement reliés en liaisons souples avec le circuit de refroidissement de la plaque froide permet une grande flexibilité pour le démontage des processeurs et garantit une fiabilité des connexions après un grand nombre de cycles d'opération de démontage. Une étanchéité à 10 bars est garantie par le système de refroidissement selon l'invention, y compris après plusieurs opérations de démontage. Le système de refroidissement selon l'invention, en raison de sa structure avec blocs de refroidissement reliés en liaisons souples avec le circuit de refroidissement de la plaque froide, permet l'implantation d'une pluralité de dissipateurs de chaleur en série ou en parallèle, par exemple au nombre de six.

Avantageusement, le connecteur de sortie chaud du dissipateur thermique d'entrée est relié au connecteur d'entrée chaud du dissipateur thermique de sortie par un premier tube de liaison flexible et/ou rectiligne et le connecteur de sortie froid du dissipateur thermique d'entrée est relié au connecteur d'entrée froid du dissipateur thermique de sortie par un deuxième tube de liaison flexible et/ou rectiligne.

De préférence, lorsque le premier tube de liaison et le deuxième tube de liaison sont rectilignes, ils sont disposés parallèlement entre eux afin d'optimiser l'espace et réduire ainsi le volume du système.

Dans une forme de réalisation, l'au moins un ensemble de dissipateurs thermiques comprend un dissipateur thermique intercalaire tel que présenté ci-avant, connecté fluidiquement d'une part au connecteur de sortie chaud et au connecteur de sortie froid du dissipateur thermique d'entrée et d'autre part au connecteur d'entrée chaud et au connecteur d'entrée froid du dissipateur thermique de sortie.

Selon un aspect de l'invention, le système peut comprendre une pluralité d'ensembles de dissipateurs thermiques, de préférence disposés parallèlement entre eux afin d'optimiser l'espace et réduire ainsi le volume du système.

Avantageusement, le tube d'entrée de chaque dissipateur thermique d'entrée est flexible afin de faciliter l'assemblage par liaisons souples avec la plaque froide.

Avantageusement encore, le tube de sortie de chaque dissipateur thermique de sortie est flexible afin de faciliter l'assemblage par liaisons souples avec la plaque froide.

Avantageusement encore, l'au moins un dissipateur thermique intercalaire est relié au dissipateur thermique d'entrée et/ou au dissipateur thermique de sortie via des tubes de liaison flexibles et/ou rectilignes.

L'invention concerne également un procédé de séparation d'un flux de fluide caloporteur dit « froid » dans un dissipateur thermique d'entrée tel que présenté ci-avant pour un système de refroidissement liquide d'une carte électronique, ladite carte comportant au moins un composant électronique, par exemple un processeur, un régulateur de tension ou une barrette mémoire, par exemple monté(e) sur un support, ledit système comprenant une plaque froide destinée à recevoir ledit dissipateur thermique, ladite plaque froide étant dimensionnée pour recouvrir au moins en partie la carte électronique, notamment le support de l'au moins un composant électronique le cas échéant, et comprenant un circuit de refroidissement comportant des canaux à l'intérieur desquels circule un fluide caloporteur dit « froid », destiné à alimenter au moins ledit dissipateur thermique, et un circuit d'évacuation comportant des canaux à l'intérieur desquels circule un fluide caloporteur dit « chaud » s'étant réchauffé à travers le dissipateur thermique, ledit procédé comprenant les étapes d'alimentation du connecteur d'entrée froid par le fluide caloporteur provenant de la plaque froide et de division dudit flux de fluide caloporteur entrant par le connecteur d'entrée froid en un premier flux, qui est orienté vers le partie inférieure du bloc de refroidissement de sorte à collecter la chaleur générée par la carte électronique en étant acheminé jusqu'au connecteur de sortie chaud, et un deuxième flux, orienté directement vers le connecteur de sortie froid.

L'invention concerne également un procédé de fusion d'un flux de fluide caloporteur dans un dissipateur thermique de sortie tel que présenté ci-avant pour un système de refroidissement liquide d'une carte électronique, ladite carte comportant au moins un composant électronique, par exemple un processeur, un régulateur de tension ou une barrette mémoire, par exemple monté(e) sur un support, ledit système comprenant une plaque froide destinée à recevoir ledit dissipateur thermique, ladite plaque froide étant dimensionnée pour recouvrir au moins en partie la carte électronique, notamment le support de l'au moins un composant électronique le cas échéant, et comprenant un circuit de refroidissement comportant des canaux à l'intérieur desquels circule un fluide caloporteur dit « froid », destiné à alimenter ledit dissipateur thermique, et un circuit d'évacuation comportant des canaux à l'intérieur desquels circule un fluide caloporteur dit « chaud » s'étant réchauffé à travers le dissipateur thermique, le procédé comprenant les étapes d'alimentation du connecteur d'entrée froid par le fluide caloporteur froid, d'alimentation du connecteur d'entrée chaud par un flux de fluide caloporteur réchauffé, d'acheminement du flux de fluide caloporteur entrant par le connecteur d'entrée froid vers la partie inférieure du bloc de refroidissement de sorte à collecter la chaleur générée par la carte électronique en étant acheminé jusqu'au connecteur de sortie et d'acheminement du flux de fluide caloporteur réchauffé reçu sur le connecteur d'entrée chaud directement vers le connecteur de sortie où il fusionne avec le flux réchauffé dans la partie inférieure du bloc de refroidissement où il fusionne avec le flux réchauffé dans la partie inférieure du bloc de refroidissement.

L'invention concerne également un procédé de gestion d'un flux de fluide caloporteur dans un dissipateur thermique intercalaire tel que présenté ci-avant pour un système de refroidissement liquide d'une carte électronique, ladite carte électronique comportant au moins un composant électronique, par exemple un processeur, un régulateur de tension ou une barrette mémoire, par exemple monté(e) sur un support, ledit système comprenant une plaque froide destinée à recevoir ledit dissipateur thermique intercalaire, ladite plaque froide étant dimensionnée pour recouvrir au moins en partie la carte électronique notamment le support de l'au moins un composant électronique le cas échéant, et comprenant un circuit de refroidissement comportant des canaux à l'intérieur desquels circule un fluide caloporteur dit « froid », destiné à alimenter au moins ledit dissipateur thermique, et un circuit d'évacuation comportant des canaux à l'intérieur desquels circule un fluide caloporteur dit « chaud » s'étant réchauffé à travers le dissipateur thermique, ledit procédé comprenant les étapes :
- d'alimentation du connecteur d'entrée froid par le fluide caloporteur provenant de la plaque froide,
- de division dudit flux de fluide caloporteur entrant par le connecteur d'entrée froid en un premier flux, qui est orienté vers la partie inférieure du bloc de refroidissement de sorte à collecter la chaleur générée par la carte électronique en étant acheminé jusqu'au connecteur de sortie chaud, et un deuxième flux, orienté directement vers le connecteur de sortie froid,
- d'alimentation du connecteur d'entrée chaud par un flux de fluide caloporteur réchauffé,
- d'acheminement du flux de fluide caloporteur réchauffé reçu sur le connecteur d'entrée chaud directement vers le connecteur de sortie chaud où il fusionne avec le flux réchauffé dans la partie inférieure du bloc de refroidissement.

Le dissipateur thermique du système de refroidissement selon l'invention doit d'ailleurs lui-même respecter une contrainte d'encombrement définie par la taille des composants (processeurs ou autres) et par la place disponible sur les plaques froides pour répartir judicieusement le fluide de refroidissement.

### [Description des dessins]

D'autres caractéristiques et avantages de l'invention apparaîtront encore à la lecture de la description qui va suivre. Celle-ci est purement illustrative et doit être lue en regard des dessins annexés sur lesquels :
[Fig 1] La figure 1 illustre schématiquement une forme de réalisation d'un système de l'art antérieur dans lequel les dissipateurs thermiques sont montés en série.
[Fig 2] La figure 2 illustre schématiquement une forme de réalisation d'un système de l'art antérieur dans lequel les dissipateurs thermiques sont montés en parallèle.
[Fig 3] La figure 3 illustre schématiquement une forme de réalisation du système selon l'invention.
[Fig 4] La figure 4 illustre schématiquement, partiellement, un ensemble de dissipateurs thermiques du système de la figure 3.
[Fig 5] La figure 5 illustre schématiquement, partiellement, un ensemble de dissipateurs thermiques comprenant un dissipateur thermique intercalaire.
[Fig 6] La figure 6 illustre schématiquement un mode de réalisation du procédé selon l'invention.

### [Description des modes de réalisation]

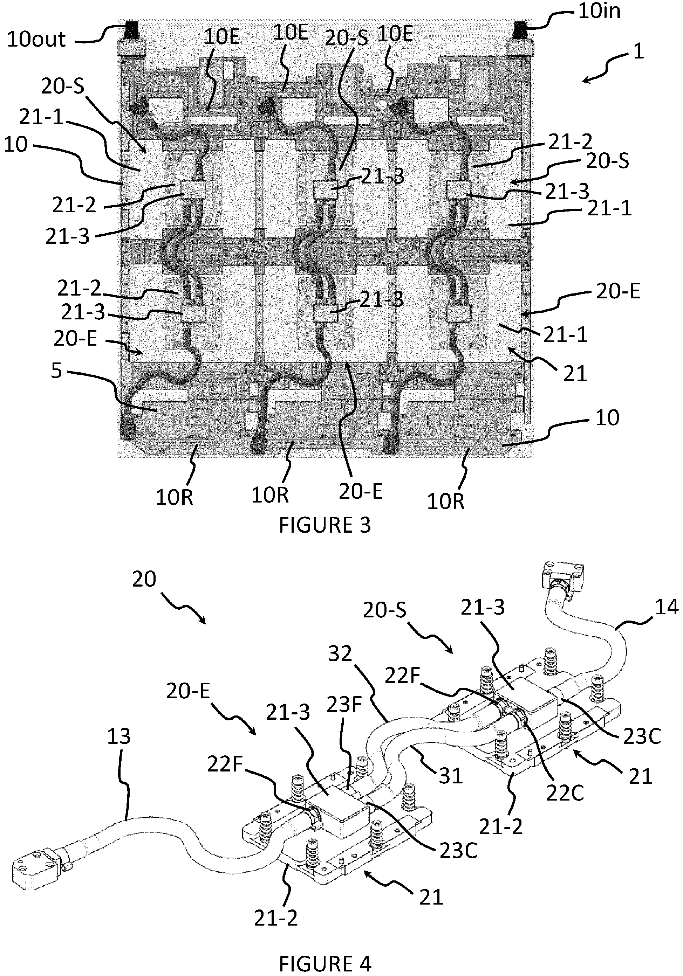

La figure 3 illustre un exemple de système 1 selon l'invention.

Le système 1 permet le refroidissement liquide d'une carte électronique 5 (visible en partie en transparence) et comprend à cette fin une plaque froide 10 et des ensembles 20 de dissipateurs thermiques 20-E, 20-S, dont un est représenté isolément (et partiellement) sur la figure 4.

La carte électronique 5 comprend dans cet exemple six processeurs montés sur un support (non visible) de la carte électronique 5. La carte électronique 5 comprend une pluralité de composants électroniques fixés sur le support, se décomposant par exemple en composants électroniques bas et moyens et en composants électroniques hauts comportant les processeurs.

Par composants électroniques bas et moyens, on entend, au sens de la présente invention, tout composant de la carte électronique 5 présentant une hauteur inférieure à une hauteur seuil, au-dessous de laquelle il peut être refroidi par le circuit de refroidissement de la plaque froide 10. Pour ce qui concerne les composants électroniques bas et moyens, il s'agit en général d'alimentations ou de régulateurs de tension.

Par composants électroniques hauts, on entend, au sens de la présente invention, tout composant de la carte électronique 5 qui n'est pas refroidi par le circuit de refroidissement de la plaque froide 10 car ils doivent rester accessibles sans démontage de la plaque froide 10. Il s'agit de composants électroniques nécessitant une maintenance rapide comme les processeurs ou les barrettes mémoires.

Dans l'exemple de la figure 3, le système 1 comprend, outre la plaque froide 10, trois ensembles 20 de dissipateurs thermiques 20-E, 20-S disposés parallèlement entre eux et comprenant chacun un dissipateur thermique d'entrée 20-E et un dissipateur thermique de sortie 20-S.

La plaque froide 10 est dimensionnée pour recouvrir le support des processeurs. Dans cet exemple, la plaque froide 10 présente des dimensions extérieures sensiblement égales à celles dudit support de la carte électronique 5 de sorte qu'elle recouvre l'intégralité du support et les composants électroniques bas et moyens.

La plaque froide 10 comprend un circuit de refroidissement 10R et un circuit d'évacuation 10E. Le circuit de refroidissement 10R comprend des canaux, de préférence rigides, à l'intérieur desquels circule un fluide caloporteur dit « froid » permettant d'alimenter les dissipateurs thermiques d'entrée. Le circuit d'évacuation 10E comprend des canaux à l'intérieur desquels circule un fluide caloporteur dit « chaud » s'étant réchauffé à travers les dissipateurs thermiques 20-E, 20-S.

L'alimentation en fluide caloporteur froid dans la plaque froide 10 est réalisée via un connecteur d'entrée 10in et la sortie du fluide caloporteur réchauffé hors de la plaque froide 10 se fait via un connecteur de sortie 10out.

Les dissipateurs thermiques 20-E, 20-S peuvent être de type monophasique.

Chaque dissipateur thermique 20-E, 20-S comprend une zone d'échange thermique principale apte à venir en appui contre un composant électronique haut, notamment l'un des processeurs, ou un composant électronique bas, notamment les régulateurs de tension et/ou les barrettes de mémoire.

En référence à la figure 4, chaque dissipateur thermique 20-E, 20-S comprend un bloc de refroidissement 21, au moins un connecteur d'entrée 22C, 22F et au moins un connecteur de sortie 23C, 23F (selon le type de dissipateur thermique 20-E, 20-S).

Le bloc de refroidissement 21 est réalisé en un matériau thermoconducteur tel que, par exemple, en aluminium ou alliage d'aluminium.

Le bloc de refroidissement 21 comprend une partie inférieure 21-1 constituant la zone d'échange thermique principale, une partie intermédiaire 21-2 dite « de répartition » (optionnelle) et une partie supérieure 21-3 connectée à la plaque froide 10.

De préférence, dans une forme de réalisation, le bloc de refroidissement 21 comprend une fente traversante située dans la partie intermédiaire pour répartir de manière homogène l'écoulement du fluide caloporteur en provenance de la partie supérieure sous forme de jet centré vers une plaque support située dans la zone d'échange thermique principale et comportant une partie centrale creuse avec une zone munie d'ailettes ou de picots pour générer de la turbulence dans le régime d'écoulement dudit fluide caloporteur et une zone périphérique à ladite zone munie d'ailettes ou de picots pour recueillir le fluide caloporteur et le diriger vers ledit connecteur de sortie. De préférence, la fente est fine. Ainsi, dans cette configuration, le fluide caloporteur, lorsqu'il arrive dans le bloc de refroidissement 21, traverse la fine fente, qui permet sa répartition équitable dans la surface d'échange au travers des ailettes. La forme de ce répartiteur et sa distance par rapport aux ailettes sont étudiées de manière à obtenir un nombre de Reynolds le plus grand possible dans l'encombrement disponible.

### Dissipateur thermique d'entrée 20-E

Toujours en référence aux figures 3 et 4, chaque dissipateur thermique d'entrée 20-E comprend un connecteur d'entrée dit « froid » 22F, un connecteur de sortie dit « chaud » 23C et un connecteur de sortie dit « froid » 23F.

Le connecteur d'entrée froid 22F est relié fluidiquement à la partie supérieure du bloc de refroidissement 21 et reçoit un tube d'entrée 13, de préférence flexible, connecté au circuit de refroidissement 10R pour alimenter le bloc de refroidissement 21 avec le fluide caloporteur provenant de la plaque froide 10.

La partie supérieure du bloc de refroidissement 21 est configurée pour diviser le flux de fluide caloporteur entrant par le connecteur d'entrée froid 22F en un premier flux et un deuxième flux. De préférence, cette division est réalisée en mettant en oeuvre une boucle de Tickelman, connue en soi, au niveau du bloc de refroidissement 21.

Le premier flux est orienté vers le partie inférieure du bloc de refroidissement 21 de sorte à collecter la chaleur générée par la carte électronique 5 en étant acheminé jusqu'au connecteur de sortie chaud 23C.

Le deuxième flux est orienté directement vers le connecteur de sortie froid 23F.

### Dissipateur thermique de sortie 20-S

Chaque dissipateur thermique de sortie 20-S comprend un connecteur d'entrée dit « chaud » 22C, un connecteur d'entrée dit « froid » 22F et un connecteur de sortie dit « chaud » 23C.

Le connecteur d'entrée chaud 22C est relié fluidiquement à la partie supérieure du bloc de refroidissement 21 et reçoit un premier tube de liaison 31, de préférence flexible, d'un flux de fluide caloporteur réchauffé par le dissipateur thermique d'entrée 20-E, connecté au connecteur de sortie chaud 23C du dissipateur thermique d'entrée 20-E.

Le connecteur d'entrée froid 22F est relié fluidiquement à la partie supérieure du bloc de refroidissement 21 et reçoit un deuxième tube de liaison 32, de préférence flexible, connecté au connecteur de sortie froid du dissipateur thermique d'entrée 20-E, de sorte que le bloc de refroidissement 21 soit alimenté par le fluide caloporteur provenant de la plaque froide 10 à travers le dissipateur thermique d'entrée 20-E, notamment du connecteur de sortie froid 23F du dissipateur thermique d'entrée 20-E.

La partie supérieure du bloc de refroidissement 21 est configurée pour d'une part acheminer le flux de fluide caloporteur entrant par le connecteur d'entrée froid 22F vers la partie inférieure du bloc de refroidissement 21 de sorte à collecter la chaleur générée par la carte électronique 5 en étant acheminé jusqu'au connecteur de sortie chaud 23C, et d'autre part acheminer le flux de fluide caloporteur réchauffé reçu sur le connecteur d'entrée chaud 22C directement vers le connecteur de sortie chaud 23C. De préférence, cette fusion est réalisée en mettant en oeuvre une boucle de Tickelman, connue en soi, au niveau du bloc de refroidissement 21.

Le connecteur de sortie chaud 23C du dissipateur thermique de sortie 20-S est relié au circuit d'évacuation de la plaque froide par un tube de sortie 14.

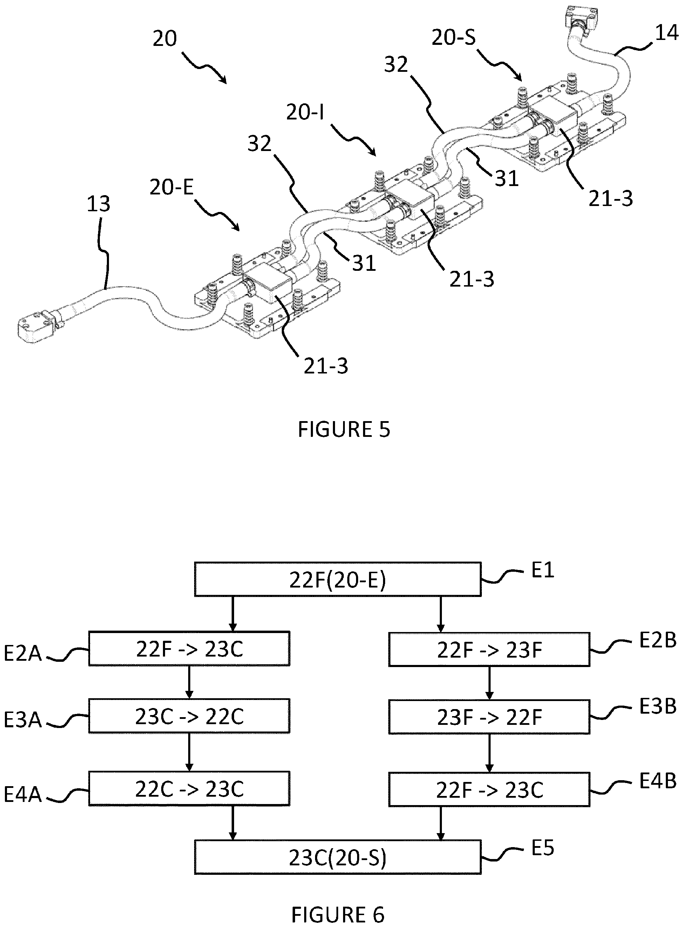

Dans une deuxième forme de réalisation, illustrée sur la figure 5, chaque ensemble de dissipateurs thermiques comprend en outre un dissipateur thermique intercalaire 20-I, connecté fluidiquement d'une part au connecteur de sortie chaud 23C et au connecteur de sortie froid 23F du dissipateur thermique d'entrée 20-E et d'autre part au connecteur d'entrée chaud 22C et au connecteur d'entrée froid 22F du dissipateur thermique de sortie 20-S. Cette configuration permet de refroidir une matrice de 3 x 3 (soit 9) processeurs (ou plus) simultanément.

Le dissipateur thermique intercalaire 20-I comprend un connecteur d'entrée dit « froid » 22F destiné à être connecté fluidiquement au connecteur de sortie froid 23F du dissipateur thermique d'entrée 20-E et relié fluidiquement à la partie supérieure 21-3 dudit bloc de refroidissement 21 de sorte que ledit bloc de refroidissement 21 soit alimenté par le fluide caloporteur froid. Le dissipateur thermique intercalaire 20-I comprend un connecteur d'entrée dit « chaud » 22C destiné à être connecté fluidiquement au connecteur de sortie chaud 23C du dissipateur thermique d'entrée 20-E et relié fluidiquement à la partie supérieure 21-3 dudit bloc de refroidissement 21. Le dissipateur thermique intercalaire 20-I comprend un connecteur de sortie dit « chaud » 23C destiné à être connecté fluidiquement au connecteur d'entrée chaud 22C du dissipateur thermique de sortie 20-S. Le dissipateur thermique intercalaire 20-I comprend un connecteur de sortie dit « froid » 23F destiné à être connecté fluidiquement au connecteur d'entrée froid 22F du dissipateur thermique de sortie 20-S. La partie supérieure 21-3 du bloc de refroidissement 21 est configurée pour diviser le flux de fluide caloporteur entrant par le connecteur d'entrée froid 22F en un premier flux, qui est orienté vers le partie inférieure 21-1 du bloc de refroidissement 21 de sorte à collecter la chaleur générée par la carte électronique 5 en étant acheminé jusqu'au connecteur de sortie chaud 23C, et un deuxième flux, orienté directement vers le connecteur de sortie froid 23F, et acheminer le flux de fluide caloporteur réchauffé reçu sur le connecteur d'entrée chaud 22C directement vers le connecteur de sortie chaud 23C.

Dans une autre forme de réalisation, le système 1 pourrait comprendre plus ou moins de trois ensembles de dissipateurs thermiques et chaque ensemble de dissipateurs thermiques pourrait comprendre, outre un dissipateur thermique d'entrée 20-E et un dissipateur thermique de sortie 20-S, un ou plusieurs dissipateurs thermiques intercalaires 20-1, connectés en série.

### Exemple de mise en oeuvre

Le fluide caloporteur circulant dans le circuit de refroidissement de la plaque froide, avant d'entrer dans les dissipateurs thermiques d'entrée, est dit « froid ». Le fluide caloporteur circulant dans le circuit d'évacuation de la plaque froide après avoir traversé les ensembles de dissipateurs thermiques est dit « chaud ».

Ainsi, en référence à la figure 6, dans une étape E1, le fluide caloporteur froid est acheminé par le circuit de refroidissement jusqu'au connecteur d'entrée froid 22F de chaque dissipateur thermique d'entrée 20-E afin de l'alimenter.

Chaque dissipateur thermique d'entrée 20-E divise le flux de fluide caloporteur froid entrant par le connecteur d'entrée froid 22F en un premier flux et en un deuxième flux, sensiblement égaux en débit, ledit débit étant de l'ordre de la moitié du débit du flux entrant.

Le premier flux est orienté du connecteur d'entrée froid 22F vers le partie inférieure 21-3 du bloc de refroidissement 21 dans une étape E2A de sorte à collecter la chaleur générée par la carte électronique 5 puis à être acheminé jusqu'au connecteur de sortie chaud 23C.

Le deuxième flux est orienté dans une étape E2B directement vers le connecteur de sortie froid 23F sans passer par la partie inférieure 21-3 du bloc de refroidissement 21 et donc sans subir de réchauffement par la carte électronique 5.

Dans une étape E3A, le premier flux réchauffé est acheminé du connecteur de sortie chaud 23C du dissipateur thermique d'entrée 20-E vers le connecteur d'entrée chaud 22C du dissipateur thermique de sortie 20-S via le premier tube de liaison 31.

Dans une étape E3B, le deuxième flux, composé de fluide caloporteur froid, est acheminé en entrée du connecteur d'entrée froid 22F du dissipateur thermique de sortie 20-S.

Dans une étape E4A, le flux de fluide caloporteur réchauffé est transféré directement du connecteur d'entrée chaud 22C du dissipateur thermique de sortie 20-S vers le connecteur de sortie chaud 23C du dissipateur thermique de sortie 20-S.

Dans une étape E4B, le deuxième flux est acheminé vers la partie inférieure 21-3 du bloc de refroidissement 21 du dissipateur thermique de sortie 20-S de sorte à collecter la chaleur générée par la carte électronique 5 puis jusqu'au connecteur de sortie chaud 23C du dissipateur thermique de sortie 20-S où il se mélange, dans une étape E5, au flux de fluide caloporteur réchauffé fourni par l'étape E4A, de sorte à retrouver le débit initial du flux d'entrée de l'étape E1.

L'invention permet de disposer des ensembles 20 de dissipateurs thermiques 20-E, 20-S en parallèle en réduisant le nombre de tubes d'entrée 13 et de tubes de sortie 14 tout en permettant une maintenance aisée.

## Revendications

1. Dissipateur thermique de sortie (20-S) pour un système (1) de refroidissement liquide d'une carte électronique (5), ladite carte électronique (5) comportant au moins un composant électronique, ledit système (1) comprenant une plaque froide (10) destinée à recevoir ledit dissipateur thermique (20-S), ladite plaque froide (10) étant dimensionnée pour recouvrir au moins en partie ladite carte électronique (5) et comprenant un circuit de refroidissement (10R) comportant des canaux à l'intérieur desquels circule un fluide caloporteur dit « froid », destiné à alimenter ledit dissipateur thermique (20-S), et un circuit d'évacuation (10E) comportant des canaux à l'intérieur desquels circule un fluide caloporteur dit « chaud » s'étant réchauffé à travers le dissipateur thermique (20-S), le dissipateur thermique (20-S) comprenant un bloc de refroidissement (21) comprenant une partie inférieure (21-1) constituant la zone d'échange thermique principale et une partie supérieure (21-3) destinée à être connectée à la plaque froide (10), le dissipateur thermique de sortie (20-S) étant **caractérisé en ce qu'**il comprend :
- un connecteur d'entrée dit « froid » (22F) relié fluidiquement à la partie supérieure (21-3) dudit bloc de refroidissement (21) et qui est destiné à recevoir un tube de liaison (32) du circuit de refroidissement (10R) de sorte que ledit bloc de refroidissement (21) soit alimenté par le fluide caloporteur provenant de la plaque froide (10),
- un connecteur d'entrée dit « chaud » (22C) relié fluidiquement à la partie supérieure (21-3) dudit bloc de refroidissement (21) et qui est destiné à recevoir un tube de liaison (31) d'un flux de fluide caloporteur réchauffé,
- un connecteur de sortie (23C) dit « chaud »,
la partie supérieure (21-3) du bloc de refroidissement (21) étant configurée pour d'une part acheminer le flux de fluide caloporteur entrant par le connecteur d'entrée froid (22F) vers la partie inférieure (21-1) du bloc de refroidissement (21) de sorte à collecter la chaleur générée par la carte électronique (5) en étant acheminé jusqu'au connecteur de sortie chaud (23C), et d'autre part acheminer le flux de fluide caloporteur réchauffé reçu sur le connecteur d'entrée chaud (22C) directement vers le connecteur de sortie chaud (23C).

2. Dissipateur thermique de sortie (20-S) selon la revendication 1, dans lequel le composant électronique est un processeur, un régulateur de tension ou une barrette mémoire.

3. Dissipateur thermique de sortie (20-S) selon l'une quelconque des revendications 1 ou 2, dans lequel le bloc de refroidissement (21) est réalisé en un matériau thermoconducteur.

4. Système (1) de refroidissement liquide d'une carte électronique (5), ladite carte électronique (5) comportant au moins un composant électronique, ledit système (1) comprenant une plaque froide (10) et au moins un ensemble de dissipateurs thermiques (20-E, 20S), la plaque froide (10) étant configurée pour recevoir ledit ensemble de dissipateurs thermiques (20-E, 20S), étant dimensionnée pour recouvrir au moins en partie la carte électronique (5) et comprenant un circuit de refroidissement (10R) comportant des canaux à l'intérieur desquels circule un fluide caloporteur dit « froid », destiné à alimenter au moins un des dissipateurs thermiques (20-E, 20S), et un circuit d'évacuation (10E) comportant des canaux à l'intérieur desquels circule un fluide caloporteur dit « chaud » s'étant réchauffé à travers au moins un des dissipateurs thermiques (20-E, 20S), chaque dissipateur thermique (20-E, 20S) comprenant une zone d'échange thermique principale apte à venir en appui contre l'un des composants électroniques, chaque ensemble de dissipateurs thermiques (20-E, 20S) comprenant un dissipateur thermique de sortie (20-S) selon l'une quelconque des revendications 1 à 3 et un dissipateur thermique d'entrée (20-E) comprenant un bloc de refroidissement (21) comprenant une partie inférieure (21-1) constituant la zone d'échange thermique principale et une partie supérieure (21-3) destinée à être connectée à la plaque froide (10), le dissipateur thermique d'entrée (20-E) comprenant :
- un connecteur d'entrée dit « froid » (22F) relié fluidiquement à la partie supérieure dudit bloc de refroidissement (21) et recevant un tube d'entrée (13) du circuit de refroidissement (10R) de sorte que ledit bloc de refroidissement (21) soit alimenté par le fluide caloporteur provenant de la plaque froide (10),
- un connecteur de sortie dit « chaud » (23C),
- un connecteur de sortie dit « froid » (23F),
la partie supérieure (21-3) du bloc de refroidissement (21) étant configurée pour diviser le flux de fluide caloporteur entrant par le connecteur d'entrée froid (22F) en un premier flux, qui est orienté vers la partie inférieure (21-1) du bloc de refroidissement (21) de sorte à collecter la chaleur générée par la carte électronique (5) en étant acheminé jusqu'au connecteur de sortie chaud (23C), et un deuxième flux, orienté directement vers le connecteur de sortie froid (23F), le connecteur de sortie froid (23F) du dissipateur thermique d'entrée (20-E) étant relié fluidiquement au connecteur d'entrée froid (22F) du dissipateur thermique de sortie (20-S), le connecteur de sortie chaud (23C) du dissipateur thermique d'entrée (20-E) étant relié fluidiquement au connecteur d'entrée chaud (22C) du dissipateur thermique de sortie (20-S), le connecteur de sortie chaud (23C) du dissipateur thermique de sortie (20-S) étant relié au circuit d'évacuation (10E) par un tube de sortie (14).

5. Système (1) selon la revendication 4, dans lequel le connecteur de sortie chaud (23C) du dissipateur thermique d'entrée (20-E) est relié au connecteur d'entrée chaud (22C) du dissipateur thermique de sortie (20-S) par un premier tube de liaison (31) flexible et/ou rectiligne et le connecteur de sortie froid (23F) du dissipateur thermique d'entrée (20-E) est relié au connecteur d'entrée froid (22F) du dissipateur thermique de sortie (20-S) par une deuxième tube de liaison (32) flexible et/ou rectiligne.

6. Système (1) selon la revendication 4, dans lequel l'au moins un ensemble de dissipateurs thermiques (20-E, 20-S) comprend un dissipateur thermique intercalaire (20-1) comprenant un bloc de refroidissement (21) comportant une partie inférieure (21-1) constituant la zone d'échange thermique principale et une partie supérieure (21-3) destinée à être connectée à la plaque froide (10), le dissipateur thermique intercalaire (20-I) comprenant :
- un connecteur d'entrée dit « froid » (22F) connecté fluidiquement au connecteur de sortie froid (23F) du dissipateur thermique d'entrée (20-E) et relié fluidiquement à la partie supérieure (21-3) dudit bloc de refroidissement (21) de sorte que ledit bloc de refroidissement (21) soit alimenté par le fluide caloporteur froid,
- un connecteur d'entrée dit « chaud » (22C) connecté fluidiquement au connecteur de sortie chaud (23C) du dissipateur thermique d'entrée (20-E) et relié fluidiquement à la partie supérieure (21-3) dudit bloc de refroidissement (21),
- un connecteur de sortie dit « chaud » (23C) connecté fluidiquement au connecteur d'entrée chaud (22C) du dissipateur thermique de sortie (20-S),
- un connecteur de sortie dit « froid » (23F) connecté fluidiquement au connecteur d'entrée froid (22F) du dissipateur thermique de sortie (20-S),
la partie supérieure (21-3) du bloc de refroidissement (21) étant configurée pour :
- diviser le flux de fluide caloporteur entrant par le connecteur d'entrée froid (22F) en un premier flux, qui est orienté vers le partie inférieure (21-1) du bloc de refroidissement (21) de sorte à collecter la chaleur générée par la carte électronique (5) en étant acheminé jusqu'au connecteur de sortie chaud (23C), et un deuxième flux, orienté directement vers le connecteur de sortie froid (23F),
- acheminer le flux de fluide caloporteur réchauffé reçu sur le connecteur d'entrée chaud (22C) directement vers le connecteur de sortie chaud (23C).

7. Système (1) selon l'une quelconque des revendications 4 à 6, comprenant une pluralité d'ensembles de dissipateurs thermiques (20-E, 20-I, 20-S) disposés parallèlement entre eux.

8. Système (1) selon l'une quelconque des revendications 4 à 7, dans lequel le tube d'entrée (13) de chaque dissipateur thermique d'entrée (20-E) est flexible.

9. Système (1) selon l'une quelconque des revendications 4 à 7, dans lequel le tube de sortie (14) de chaque dissipateur thermique de sortie (20-S) est flexible.

10. Procédé de fusion d'un flux de fluide caloporteur dans un dissipateur thermique de sortie (20-S) selon l'une quelconque des revendications 1 à 3 pour un système (1) de refroidissement liquide d'une carte électronique (5), ladite carte électronique (5) comportant au moins un composant électronique, ledit système (1) comprenant une plaque froide (10) destinée à recevoir ledit dissipateur thermique (20-S), ladite plaque froide (10) étant dimensionnée pour recouvrir au moins en partie la carte électronique (5) et comprenant un circuit de refroidissement (10R) comportant des canaux à l'intérieur desquels circule un fluide caloporteur dit « froid », destiné à alimenter ledit dissipateur thermique (20-S), et un circuit d'évacuation (10E) comportant des canaux à l'intérieur desquels circule un fluide caloporteur dit « chaud » s'étant réchauffé à travers le dissipateur thermique (20-S), le procédé comprenant les étapes d'alimentation du connecteur d'entrée froid (22F) par le fluide caloporteur froid, d'alimentation du connecteur d'entrée chaud (22C) par un flux de fluide caloporteur réchauffé, d'acheminement du flux de fluide caloporteur entrant par le connecteur d'entrée froid (22F) vers la partie inférieure (21-1) du bloc de refroidissement (21) de sorte à collecter la chaleur générée par la carte électronique (5) en étant acheminé jusqu'au connecteur de sortie chaud (23C) et d'acheminement du flux de fluide caloporteur réchauffé reçu sur le connecteur d'entrée chaud (22C) directement vers le connecteur de sortie chaud (23C) où il fusionne avec le flux réchauffé dans la partie inférieure (21-1) du bloc de refroidissement (21).

## Patentansprüche

1. Auslasswärmesenke (20-S) für ein Flüssigkeitskühlsystem (1) einer Elektronikkarte (5), wobei die Elektronikkarte (5) mindestens eine Elektronikkomponente aufweist, das System (1) umfassend eine Kühlplatte (10), die dazu bestimmt ist, die Wärmesenke (20-S) aufzunehmen, wobei die Kühlplatte (10) zum Bedecken mindestens teilweise der Elektronikkarte (5) eines Kühlkreislaufs (10R) bemessen ist, und umfassend Kanäle, in denen ein sogenanntes "kühles" Wärmeübertragungsfluid zirkuliert, das dazu bestimmt ist, die Wärmesenke (20-S) zu versorgen, und einen Ableitungskreislauf (1 OE), der Kanäle aufweist, in denen ein sogenanntes "heißes" Wärmeübertragungsfluid zirkuliert, das sich durch die Wärmesenke (20-S) erhitzt hat, die Wärmesenke (20-S) umfassend einen Kühlblock (21), umfassend einen unteren Teil (21-1), der die Hauptwärmeaustauschzone bildet, und einen oberen Teil (21-3), der dazu bestimmt ist, an die Kühlplatte (10) angeschlossen zu werden, wobei die Auslasswärmesenke (20-S) **dadurch gekennzeichnet ist, dass** sie umfasst:
- einen sogenannten "kühlen" Einlassanschluss (22F), der mit dem oberen Teil (21-3) des Kühlblocks (21) fluidverbunden ist und der dazu bestimmt ist, ein Verbindungsrohr (32) des Kühlkreislaufs (10R) aufzunehmen, sodass der Kühlblock (21) mit dem Wärmeübertragungsfluid versorgt wird, das von der Kühlplatte (10) kommt,
- einen sogenannten "heißen" Einlassanschluss (22C), der mit dem oberen Teil (21-3) des Kühlblocks (21) fluidverbunden ist und der dazu bestimmt ist, ein Verbindungsrohr (31) eines erhitzten Wärmeübertragungsfluidstroms aufzunehmen,
- einen sogenannten "heißen" Auslassanschluss (23C),
wobei der obere Teil (21-3) des Kühlblocks (21) zum einerseits Befördern des Wärmeübertragungsfluidstroms, der durch den kühlen Einlassanschluss (22F) eintritt, zu dem unteren Teil (21-1) des Kühlblocks (21), um die Hitze zu sammeln, die durch die Elektronikkarte (5) erzeugt wird, indem er bis zu dem heißen Auslassanschluss (23C) befördert wird, und andererseits zum Befördern des erhitzten Wärmeübertragungsfluidstroms, der an dem heißen Einlassanschluss (22C) aufgenommen wird, direkt an den heißen Auslassanschluss (23C) konfiguriert ist.

2. Auslasswärmesenke (20-S) nach Anspruch 1, wobei die Elektronikkomponente ein Prozessor, ein Spannungsregler oder ein Speichermodul ist.

3. Auslasswärmesenke (20-S) nach einem der Ansprüche 1 oder 2, wobei der Kühlblock (21) aus einem wärmeleitenden Material hergestellt ist.

4. System (1) für eine Flüssigkeitskühlung einer Elektronikkarte (5), wobei die Elektronikkarte (5) mindestens eine Elektronikkomponente aufweist, das System (1) umfassend eine Kühlplatte (10) und mindestens einen Satz von Wärmesenken (20-E, 20S), wobei die Kühlplatte (10) zum Aufnehmen des Satzes von Wärmesenken (20-E, 20S) konfiguriert ist, zum Bedecken mindestens teilweise der Elektronikkarte (5) bemessen ist und umfassend einen Kühlkreislauf (10R), der Kanäle aufweist, in denen ein sogenanntes "kühles" Wärmeübertragungsfluid zirkuliert, das dazu bestimmt ist, mindestens eine der Wärmesenken (20-E, 20S) zu versorgen, und einen Ableitungskreislauf (10E), der Kanäle aufweist, in denen ein sogenanntes "heißes" Wärmeübertragungsfluid zirkuliert, das sich durch mindestens eine der Wärmesenken (20-E, 20S) erhitzt hat, jede Wärmesenke (20-E, 20S) umfassend eine Hauptwärmeaustauschzone, die geeignet ist, um an einer der Elektronikkomponenten anzuliegen, jeder Satz von Wärmesenken (20-E, 20S) umfassend eine Auslasswärmesenke (20-S) nach einem der Ansprüche 1 bis 3 und eine Einlasswärmesenke (20-E), umfassend einen Kühlblock (21), umfassend einen unteren Teil (21-1), der die Hauptwärmeaustauschzone bildet, und einen oberen Teil (21-3), der dazu bestimmt ist, an die Kühlplatte (10) angeschlossen zu werden, die Einlasswärmesenke (20-E) umfassend:
- einen sogenannten "kühlen" Einlassanschluss (22F), der mit dem oberen Teil des Kühlblocks (21) fluidverbunden ist und ein Einlassrohr (13) des Kühlkreislaufs (10R) aufnimmt, sodass der Kühlblock (21) mit dem Wärmeübertragungsfluid versorgt wird, das von der Kühlplatte (10) kommt,
- einen sogenannten "heißen"-Auslassanschluss (23C),
- einen sogenannten "kühlen" Auslassanschluss (23F),
wobei der obere Teil (21-3) des Kühlblocks (21) zum Aufteilen des Wärmeübertragungsfluidstroms, der durch den kühlen Einlassanschluss (22F) eintritt, in einen ersten Strom, der zu dem unteren Teil (21-1) des Kühlblocks (21) gelenkt wird, um die Hitze zu sammeln, die durch die Elektronikkarte (5) erzeugt wird, indem er bis zu dem heißen Auslassanschluss (23C) befördert wird, und einen zweiten Strom, der direkt zu dem kühlen Auslassanschluss (23F) gelenkt wird, wobei der kühle Auslassanschluss (23F) der Einlasswärmesenke (20-E) mit dem kühlen Einlassanschluss (22F) der Auslasswärmesenke (20-S) fluidverbunden ist, wobei der Auslassanschluss (23C) der Einlasswärmesenke (20-E) mit dem heißen Einlassanschluss (22C) der Auslasswärmesenke (20-S) fluidverbunden ist, wobei der heiße Auslassanschluss (23C) der Auslasswärmesenke (20-S) über ein Auslassrohr (14) mit dem Ableitungskreislauf (10E) verbunden ist.

5. System (1) nach Anspruch 4, wobei der heiße Auslassanschluss (23C) der Einlasswärmesenke (20-E) mit dem heißen Einlassanschluss (22C) der Auslasswärmesenke (20-S) über ein erstes flexibles und/oder geradliniges Verbindungsrohr (31) verbunden ist und der kühle Auslassanschluss (23F) der Einlasswärmesenke (20-E) mit dem kühlen Einlassanschluss (22F) der Auslasswärmesenke (20-S) über ein zweites flexibles und/oder geradliniges Verbindungsrohr (32) verbunden ist.

6. System (1) nach Anspruch 4, wobei der mindestens eine Satz von Wärmesenken (20-E, 20-S) eine Zwischenwärmesenke (20-I) umfasst, umfassend einen Kühlblock (21), der einen unteren Teil (21-1), der die Hauptwärmeaustauschzone bildet, und einen oberen Teil (21-3), der dazu bestimmt ist, an die Kühlplatte (10) der Wärmesenke angeschlossen zu werden, aufweist, die Zwischenwärmesenke (20-I) umfassend:
- einen sogenannten "kühlen" Einlassanschluss (22F), an den kühlen Auslassanschluss (23F) der Einlasswärmesenke (20-E) fluidisch angeschlossen ist und mit dem oberen Teil (21-3) des Kühlblocks (21) fluidverbunden ist, sodass der Kühlblock (21) mit dem kühlen Wärmeträgerfluid versorgt wird,
- einen sogenannten "heißen" Einlassanschluss (22C), der an den heißen Auslassanschluss (23C) der Einlasswärmesenke (20-E) fluidisch angeschlossen ist und mit dem oberen Teil (21-3) des Kühlblocks (21) fluidverbunden ist,
- einen sogenannten "heißen" Auslassanschluss (23C), der an den heißen Einlassanschluss (22C) der Auslasswärmesenke (20-S) fluidisch angeschlossen ist,
- einen sogenannten "kühlen" Auslassanschluss (23F), der an den kühlen Einlassanschluss (22F) der Auslasswärmesenke (20-S) fluidisch angeschlossen ist,
wobei der obere Teil (21-3) des Kühlblocks (21) konfiguriert ist zum:
- Aufteilen des Wärmeübertragungsfluidstroms, der durch den kühlen Einlassanschluss (22F) eintritt, in einen ersten Strom, der zu dem unteren Teil (21-1) des Kühlblocks (21) gelenkt wird, um die Hitze zu sammeln, die durch die Elektronikkarte (5) erzeugt wird, indem er bis zu dem heißen Auslassanschluss (23C) befördert wird, und einen zweiten Strom, der direkt zu dem kühlen Auslassanschluss (23F) gelenkt wird,
- Befördern des erhitzten Wärmeübertragungsfluidstroms, der an dem heißen Einlassanschluss (22C) aufgenommen wird, direkt zu dem heißen Auslassanschluss (23C).

7. System (1) nach einem der Ansprüche 4 bis 6, umfassend eine Vielzahl von Sätzen von Wärmesenken (20-E, 20-I, 20-S), die parallel zueinander angeordnet sind.

8. System (1) nach einem der Ansprüche 4 bis 7, wobei das Einlassrohr (13) jede Einlasswärmesenke (20-E) flexibel ist.

9. System (1) nach einem der Ansprüche 4 bis 7, wobei das Auslassrohr (14) jeder Auslasswärmesenke (20-S) flexibel ist.

10. Verfahren zum Zusammenführen eines Wärmeübertragungsfluidstroms in einer Auslasswärmesenke (20-S) nach einem der Ansprüche 1 bis 3 für ein Flüssigkeitskühlungssystem (1) einer Elektronikkarte (5), wobei die Elektronikkarte (5) mindestens eine Elektronikkomponente aufweist, das System (1) umfassend eine Kühlplatte (10), die dazu bestimmt ist, die Wärmesenke (20-S) aufzunehmen, wobei die Kühlplatte (10) zum Bedecken mindestens teilweise der Elektronikkarte (5) bemessen ist, und umfassend einen Kühlkreislauf (10R), der Kanäle aufweist, in denen ein sogenanntes "kühles" Wärmeübertragungsfluid zirkuliert, das dazu bestimmt ist, die Wärmesenke (20-S) zu versorgen, und einen Ableitungskreislauf (10E), der Kanäle umfasst, in denen ein sogenanntes "heißes" Wärmeübertragungsfluid zirkuliert, das sich durch die Wärmesenke (20-S) erhitzt hat, das Verfahren umfassend die Schritte des Versorgens des kühlen Einlassanschlusses (22F) mit dem kühlen Wärmeübertragungsfluid, des Versorgens des heißen Einlassanschlusses (22C) mit einem erhitzten Wärmeübertragungsfluidstrom, des Beförderns des Wärmeübertragungsfluidstroms, der durch den kühlen Einlassanschluss (22F) eintritt, in Richtung des unteren Teils (21-1) des Kühlblocks (21), um die Wärme zu sammeln, die durch die Elektronikkarte (5) erzeugt wird, indem er zu dem heißen Auslassanschluss (23C) befördert wird, und des Beförderns des erhitzten Wärmeübertragungsfluidstroms, der an dem heißen Einlassanschluss (22C) aufgenommen wird, direkt zu dem heißen Auslassanschluss (23C), wo er mit dem erhitzten Strom in dem unteren Teil (21-1) des Kühlblocks (21) zusammengeführt wird.

## Claims

1. Outlet heat sink (20-S) of a liquid cooling system (1) for an electronic board (5), said electronic board (5) including at least one electronic component, said system (1) comprising a cold plate (10) for receiving said heat sink (20-S), said cold plate (10) being sized to at least partially cover said electronic board (5) and comprising a cooling circuit (10R) including channels inside which circulates a so-called "cold" heat transfer fluid for supplying said heat sink (20-S), and a discharge circuit (10E) including channels inside which circulates a so-called "hot" heat transfer fluid having been heated through the heat sink (20-S), the heat sink (20-S) comprising a cooling block (21) comprising a lower portion (21-1) constituting the main heat exchange zone and an upper portion (21-3) intended to be connected to the cold plate (10), the outlet heat sink (20-S) being **characterised in that** it comprises:
- a so-called "cold" inlet connector (22F) which is fluidically connected to the upper portion (21-3) of said cooling block (21) and which is intended to receive a connecting tube (32) of the cooling circuit (10R) so that said cooling block (21) is supplied with the heat transfer fluid from the cold plate (10),
- a so-called "hot" inlet connector (22C) which is fluidically connected to the upper portion (21-3) of said cooling block (21) and which is intended to receive a connecting tube (31) for a flow of heated heat transfer fluid,
- a so-called "hot" outlet connector (23C),
the upper portion (21-3) of the cooling block (21) being configured to route the flow of heat transfer fluid entering through the cold inlet connector (22F) towards the lower portion (21-1) of the cooling block (21) so as to collect the heat generated by the electronic board (5) by being routed to the hot outlet connector (23C), and to route the flow of heated heat transfer fluid received at the hot inlet connector (22C) directly towards the hot outlet connector (23C).

2. Outlet heat sink (20-S) according to claim 1, wherein the electronic component is a processor, a voltage regulator or a memory module.

3. Outlet heat sink (20-S) according to any one of claims 1 or 2, wherein the cooling block (21) is made of a thermally conductive material.

4. Liquid cooling system (1) for an electronic board (5), said electronic board (5) including at least one electronic component, said system (1) comprising a cold plate (10) and at least one assembly of heat sinks (20-E, 20S), the cold plate (10) being configured to receive said assembly of heat sinks (20-E, 20S), being sized to at least partially cover the electronic board (5) and comprising a cooling circuit (10R) including channels inside which circulates a so-called "cold" heat transfer fluid for supplying at least one of the heat sinks (20-E, 20S), and a discharge circuit (10E) including channels inside which circulates a so-called "hot" heat transfer fluid having been heated through at least one of the heat sinks (20-E, 20S), each heat sink (20-E, 20S) comprising a main heat exchange zone suitable for bearing against one of the electronic components, each assembly of heat sinks (20-E, 20S) comprising an outlet heat sink (20-S) according to any one of claims 1 to 3 and an inlet heat sink (20-E) comprising a cooling block (21) comprising a lower portion (21-1) constituting the main heat exchange zone and an upper portion (21-3) which is intended to be connected to the cold plate (10), the inlet heat sink (20-E) comprising:
- a so-called "cold" inlet connector (22F) which is fluidically connected to the upper portion of said cooling block (21) and receiving an inlet tube (13) of the cooling circuit (10R) so that said cooling block (21) is supplied with the heat transfer fluid from the cold plate (10),
- a so-called "hot" outlet connector (23C),
- a so-called "cold" outlet connector (23F),
the upper portion (21-3) of the cooling block (21) being configured to divide the flow of heat transfer fluid entering through the cold inlet connector (22F) into a first flow, which is directed towards the lower portion (21-1) of the cooling block (21) so as to collect the heat generated by the electronic board (5) by being routed to the hot outlet connector (23C), and a second flow, directed directly towards the cold outlet connector (23F), the cold outlet connector (23F) of the inlet heat sink (20-E) being fluidically connected to the cold inlet connector (22F) of the outlet heat sink (20-S), the hot outlet connector (23C) of the inlet heat sink (20-E) being fluidically connected to the hot inlet connector (22C) of the outlet heat sink (20-S), the hot outlet connector (23C) of the outlet heat sink (20-S) being connected to the discharge circuit (10E) by an outlet tube (14).

5. System (1) according to claim 4, wherein the hot outlet connector (23C) of the inlet heat sink (20-E) is connected to the hot inlet connector (22C) of the outlet heat sink (20-S) by a first flexible and/or straight connecting tube (31) and the cold outlet connector (23F) of the inlet heat sink (20-E) is connected to the cold inlet connector (22F) of the outlet heat sink (20-S) by a second flexible and/or straight connecting tube (32).

6. System (1) according to claim 4, wherein the at least one assembly of heat sinks (20-E, 20-S) comprises an intermediate heat sink (20-I) comprising a cooling block (21) including a lower portion (21-1) constituting the main heat exchange area and an upper portion (21-3) which is intended to be connected to the cold plate (10), the intermediate heat sink (20-I) comprising:
- a so-called "cold" inlet connector (22F) which is fluidically connected to the cold outlet connector (23F) of the inlet heat sink (20-E) and fluidically connected to the upper portion (21-3) of said cooling block (21) so that said cooling block (21) is supplied with cold heat transfer fluid,
- a so-called "hot" inlet connector (22C) which is fluidically connected to the hot outlet connector (23C) of the inlet heat sink (20-E) and is fluidically connected to the upper portion (21-3) of said cooling block (21),
- a so-called "hot" outlet connector (23C) which is fluidically connected to the hot inlet connector (22C) of the outlet heat sink (20-S),
- a so-called "cold" outlet connector (23F) which is fluidically connected to the cold inlet connector (22F) of the outlet heat sink (20-S),
the upper portion (21-3) of the cooling block (21) being configured to:
- divide the flow of heat transfer fluid entering through the cold inlet connector (22F) into a first flow, which is directed towards the lower portion (21-1) of the cooling block (21) so as to collect the heat generated by the electronic board (5) by being routed to the hot outlet connector (23C), and a second flow which is directed directly towards the cold outlet connector (23F),
- route the flow of heated heat transfer fluid received at the hot inlet connector (22C) directly towards the hot outlet connector (23C).

7. System (1) according to any one of claims 4 to 6, comprising a plurality of heat sink assemblies (20-E, 20-I, 20-S) arranged parallel to one another.

8. System (1) according to any one of claims 4 to 7, wherein the inlet tube (13) of each inlet heat sink (20-E) is flexible.

9. System (1) according to any one of claims 4 to 7, wherein the outlet tube (14) of each outlet heat sink (20-S) is flexible.

10. Method for merging a flow of heat transfer fluid in an outlet heat sink (20-S) according to any one of claims 1 to 3 for a liquid cooling system (1) for an electronic board (5), said electronic board (5) including at least one electronic component, said system (1) comprising a cold plate (10) for receiving said heat sink (20-S), said cold plate (10) being sized to at least partially cover the electronic board (5) and comprising a cooling circuit (10R) including channels inside which circulates a "cold" heat transfer fluid for supplying said heat sink (20-S), and a discharge circuit (10E) including channels inside which circulates a "hot" heat transfer fluid having been heated through the heat sink (20-S), the method comprising the steps of supplying the cold inlet connector (22F) with the cold heat transfer fluid, supplying the hot inlet connector (22C) with a flow of heated heat transfer fluid, routing the flow of heat transfer fluid entering through the cold inlet connector (22F) towards the lower portion (21-1) of the cooling block (21) so as to collect the heat generated by the electronic board (5) by being routed to the hot outlet connector (23C) and routing the flow of heated heat transfer fluid received at the hot inlet connector (22C) directly towards the hot outlet connector (23C) where it merges with the heated flow in the lower portion (21-1) of the cooling block (21).
